# EUROPÄISCHE PATENTANMELDUNG

(11) **EP 2 261 972 A2**
(43) Veröffentlichungstag der Anmeldung: **15.12.2010**
(21) Anmeldenummer: 10158560.2
(22) Anmeldetag: 31.03.2010
(51) Int. Cl.: H01L 23/66, H01Q 1/32, H01Q 9/04

(54) **Integrierter Schaltkreis mit einer Antennenanordnung**

(30) Priorität: 28.05.2009 DE 102009026550
(71) Anmelder: Robert Bosch GmbH, 70442 Stuttgart (DE)
(72) Erfinder: Wostradowski, Uwe, 71272 Renningen (DE); Gaier, Stefan, 70599 Stuttgart (DE); Hansen, Thomas, 31139 Hildesheim (DE); Selinger, Joachim, 70597 Stuttgart (DE); Freundt, Dirk, 70825 Korntal-Muenchingen (DE); Schneider, Karl, 71576 Burgstetten (DE)

(57) **Zusammenfassung**

Die vorliegende Erfindung betrifft ein Verfahren zum Herstellen eines integrierten Schaltkreises (100, 101) mit einer Antennenanordnung. Das Verfahren umfasst ein Bereitstellen eines Substrats (110), wobei das bereitgestellte Substrat (110) eine integrierte Schaltung und eine an einer Oberfläche des Substrats angeordnete erste Antennenschicht (120) aufweist, ein Ausbilden einer Trägerschicht (130) auf der Oberfläche des bereitgestellten Substrats (110), wobei die Trägerschicht (130) die erste Antennenschicht (120) bedeckt, ein Ausbilden einer leitfähigen Schicht (140) wenigstens auf der Trägerschicht (130), ein Strukturieren der leitfähigen Schicht (140) zum Ausbilden einer zweiten Antennenschicht (140) in einem Bereich über der ersten Antennenschicht (120), und ein Strukturieren der Trägerschicht (130). Die Erfindung betrifft des Weiteren einen integrierten Schaltkreis (100, 101) mit einer Antennenanordnung.

## Beschreibung

Die vorliegende Erfindung betrifft einen integrierten Schaltkreis mit einer Antennenanordnung sowie ein Verfahren zum Herstellen eines derartigen integrierten Schaltkreises.

### Stand der Technik

Bauelemente zur Abstandsmessung, welche beispielsweise in Radargeräten im Automobilbereich eingesetzt werden, weisen ein Substrat mit einer Hochfrequenzschaltung und eine auf dem Substrat ausgebildete Antennenanordnung zum Aussenden und/oder Empfangen einer elektromagnetischen Strahlung auf. Bei dem Substrat bzw. Chip handelt es sich üblicherweise um einen sogenannten MMIC-Schaltkreis (Monolithic Microwave Integrated Circuit), bei dem die zugehörige integrierte Schaltung für Arbeitsfrequenzen im Mikrowellenbereich ausgebildet ist.

Bei einem bekannten Herstellungsverfahren werden das Hochfrequenzsubstrat und die Antennenanordnung zunächst getrennt voneinander erzeugt. Erst nachfolgend werden diese beiden Komponenten miteinander verbunden. Bei einem weiteren Herstellungsverfahren, welches auch als "Antenna-on-chip"-Konzept bekannt ist, wird das Substrat zusätzlich mit einem Sendeelement in Form einer an der Substratoberfläche angeordneten Antennenschicht (Patch bzw. Patch-Antenne) ausgebildet. Zur Vervollständigung der Radarantenne wird eine zweite Antennenschicht in einem definierten Abstand über der Antenneschicht auf der Substratoberfläche angeordnet, so dass eine gestapelte Antennenanordnung ("Stacked Patch") vorliegt. Die zweite Antennenschicht dient hierbei dazu, um die elektromagnetische Strahlung mit einer ausreichenden Bandbreite aussenden und/oder empfangen zu können. Üblicherweise wird die zweite Strahlerfläche auf einem Trägerelement (beispielsweise aus Glas) ausgebildet, und das Trägerelement nachfolgend auf die Substratoberfläche des Chips aufgeklebt. Der Chip kann hierbei bereits in einem Gehäuse integriert oder auf einer Leiterplatte befestigt sein.

Das separate Herstellen von Chips und den Antennen bzw. Antennenkomponenten sowie das nachträgliche einzelne Aufbringen auf zugehörige Chipsubstrate haben zur Folge, dass die bekannten Verfahren mit einem relativ hohen Aufwand und damit relativ hohen Kosten verbunden sind.

### Offenbarung der Erfindung

Die Aufgabe der vorliegenden Erfindung besteht darin, ein verbessertes Verfahren zum Herstellen eines integrierten Schaltkreises mit einer Antennenanordnung sowie einen verbesserten integrierten Schaltkreis anzugeben.

Diese Aufgabe wird durch ein Verfahren gemäß Anspruch 1 und durch einen integrierten Schaltkreis gemäß Anspruch 10 gelöst. Weitere vorteilhafte Ausführungsformen der Erfindung sind in den abhängigen Ansprüchen angegeben.

Erfindungsgemäß wird ein Verfahren zum Herstellen eines integrierten Schaltkreises mit einer Antennenanordnung vorgeschlagen. Das Verfahren umfasst ein Bereitstellen eines Substrats, wobei das bereitgestellte Substrat eine integrierte Schaltung und eine an einer Oberfläche des Substrats angeordnete erste Antennenschicht aufweist, ein Ausbilden einer Trägerschicht auf der Oberfläche des bereitgestellten Substrats, wobei die Trägerschicht die erste Antennenschicht bedeckt, ein Ausbilden einer leitfähigen Schicht wenigstens auf der Trägerschicht, ein Strukturieren der leitfähigen Schicht zum Ausbilden einer zweiten Antennenschicht in einem Bereich über der ersten Antennenschicht, und ein Strukturieren der Trägerschicht.

Das Verfahren bietet die Möglichkeit, die einzelnen Komponenten der Antennenanordnung schichtweise bzw. nacheinander auf dem Substrat auszubilden. Auf diese Weise lässt sich die Herstellung des integrierten Schaltkreises mit der Antennenanordnung mit einem relativ geringen Aufwand durchführen, wodurch sich ferner eine Kostenersparnis ergibt. Dieser Vorteil tritt insbesondere bei der parallelen Herstellung einer Vielzahl von derartigen Schaltkreisen auf. Hierbei weist das Substrat eine Vielzahl an integrierten Schaltungen und an der Substratoberfläche angeordneten ersten Antennenschichten auf, und lassen sich durch Durchführen der oben beschriebenen Verfahrensschritte eine Vielzahl an zugehörigen zweiten Antennenschichten in einem Abstand zu den ersten Antennenschichten gemeinsam herstellen, anstelle diese einzeln auszubilden.

In einer bevorzugten Ausführungsform weist das bereitgestellte Substrat weiter eine an der Oberfläche angeordnete Kontaktfläche auf. Die Kontaktfläche wird durch das Ausbilden der Trägerschicht bedeckt und durch das Strukturieren der Trägerschicht freigelegt. Über die Kontaktfläche kann das Substrat bzw. die integrierte Schaltung kontaktiert werden.

In einer weiteren bevorzugten Ausführungsform werden das Strukturieren der leitfähigen Schicht und das Strukturieren der Trägerschicht gemeinsam durchgeführt. Auf diese Weise kann der Aufwand bei der Herstellung des integrierten Schaltkreises weiter verringert werden.

Alternativ ist die Möglichkeit gegeben, das Strukturieren der leitfähigen Schicht und das Strukturieren der Trägerschicht getrennt voneinander durchzuführen. Eine mögliche bevorzugte Ausführungsform besteht darin, das Strukturieren der Trägerschicht vor dem Ausbilden der leitfähigen Schicht durchzuführen. In einem solchen Fall kann die leitfähige Schicht nicht nur auf der Trägerschicht, sondern auch auf der Substratoberfläche bzw. auf der (freigelegten) Kontaktfläche ausgebildet werden. Durch das Strukturieren der leitfähigen Schicht kann infolgedessen nicht nur die zweite Antennenschicht gebildet werden. Ein Teil der (strukturierten) leitfähigen Schicht, welche nicht als zweite Antennenschicht fungiert, kann die Kontaktfläche weiterhin bedecken bzw. kontaktieren, um beispielsweise in Form einer Umverdrahtung eine leichtere Kontaktierung der Kontaktfläche zu ermöglichen.

In einer weiteren bevorzugten Ausführungsform umfasst das Verfahren weiter ein Verdünnen der Trägerschicht nach dem Ausbilden der Trägerschicht auf der Oberfläche des bereitgestellten Substrats. Das Verdünnen bietet die Möglichkeit, die Dicke der Trägerschicht mit einer hohen Genauigkeit festzulegen, so dass sich in entsprechender Weise der Abstand zwischen erster und zweiter Antennenschicht mit einer hohen Genauigkeit einstellen lässt.

In einer weiteren bevorzugten Ausführungsform weist die Trägerschicht ein Kunststoffmaterial auf. In Betracht kommt hierbei insbesondere Polyimid. Ein derartiges Material zeichnet sich durch Eigenschaften wie zum Beispiel eine geringe relative Permittivität und eine geringe Strahlungsabsorption aus, und ist daher für Hochfrequenzanwendungen geeignet.

In einer weiteren bevorzugten Ausführungsform umfasst das Ausbilden der Trägerschicht auf der Oberfläche des Substrats das Durchführen einer Rotationsbeschichtung. Für das Ausbilden der leitfähigen Schicht auf dem Trägermaterial kommen vorzugsweise eine elektrochemische Abscheidung oder ein Sputterprozess in Betracht.

In einer weiteren bevorzugten Ausführungsform umfasst das Verfahren weiter ein Durchführen eines Sägeprozesses. Der Sägeprozess kann dazu verwendet werden, um den integrierten Schaltkreis mit der Antennenanordnung zu vereinzeln.

Erfindungsgemäß wird des Weiteren ein integrierter Schaltkreis mit einer Antennenanordnung vorgeschlagen. Der integrierte Schaltkreis weist ein Substrat auf, wobei das Substrat eine integrierte Schaltung und eine an einer Oberfläche des Substrats angeordnete erste Antennenschicht aufweist. Weiter vorgesehen ist eine auf der Oberfläche des Substrats angeordnete Trägerschicht, welche die erste Antennenschicht bedeckt, und eine auf der Trägerschicht angeordnete zweite Antennenschicht in einem Bereich über der ersten Antennenschicht. Der integrierte Schaltkreis zeichnet sich dadurch aus, dass die Trägerschicht unmittelbar auf der Oberfläche des Substrats und auf der ersten Antennenschicht angeordnet ist. Die Trägerschicht des integrierten Schaltkreises ist somit direkt, d.h. ohne eine Zwischen- oder Klebeschicht auf der Substratoberfläche angeordnet. Ein derartiger integrierter Schaltkreis sowie insbesondere eine Anzahl derartiger integrierter Schaltkreise lassen sich mit einem geringen Aufwand, insbesondere durch Durchführen des oben beschriebenen Verfahrens, herstellen.

Die Erfindung wird im Folgenden anhand der Figuren näher erläutert. Es zeigen:
Figur 1 ein Ablaufdiagramm eines Verfahrens zum Herstellen von integrierten Schaltkreisen mit einer Antennenanordnung;
Figuren 2A bis 2D seitliche Schnittdarstellungen eines Substrats zur Veranschaulichung des Verfahrens von Figur 1;
Figur 3 ein Ablaufdiagramm eines weiteren Verfahrens zum Herstellen von integrierten Schaltkreisen mit einer Antennenanordnung; und
Figuren 4A bis 4D seitliche Schnittdarstellungen eines Substrats zur Veranschaulichung des Verfahrens von Figur 3.

Anhand der folgenden Figuren werden mögliche Verfahren zum parallelen Herstellen von integrierten Schaltkreisen 100, 101 mit einer Antennenanordnung beschrieben. Gegenüber einem einzelnen Ausbilden oder Vervollständigen von Antennen auf einem integrierten Schaltkreis ergibt sich auf diese Weise ein geringerer Herstellungs- und Kostenaufwand. Die dargestellten Schaltkreise 100, 101 können insbesondere als Bauelemente für Radaranwendungen, d.h. als Sende- und/oder Empfangseinrichtungen zum Aussenden und/oder Empfangen von elektromagnetischer Strahlung (Radar- bzw. Mikrowellen) eingesetzt werden. In Betracht kommt beispielsweise der Einsatz in einem Radarsensor im Automobilbereich, zum Beispiel in Zusammenhang mit einem Abstandshaltesystem wie ACC (Adaptive Cruise Control).

Bei den Herstellungsverfahren können in der Halbleitertechnik übliche Verfahrensprozesse und Materialien zum Einsatz kommen, so dass hierauf nur teilweise eingegangen wird. Bei einzelnen Verfahrensschritten kann es sich insbesondere um Prozesse handeln, welche im Rahmen einer Halbleiter-Backend-Fertigung zum Einsatz kommen. Darüber hinaus wird darauf hingewiesen, dass neben den dargestellten und beschriebenen Verfahrensschritten weitere Verfahrensschritte durchgeführt werden können, um die Herstellung von integrierten Schaltkreisen 100, 101 zu vervollständigen. Im Hinblick auf die angegebenen Materialien, welche als Beispiele anzusehen sind, können auch andere Materialien eingesetzt werden.

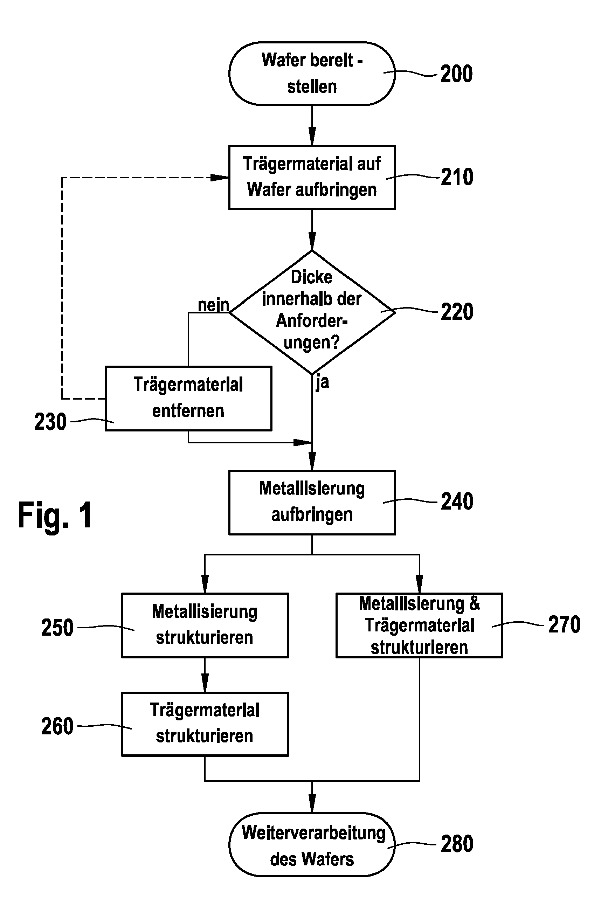

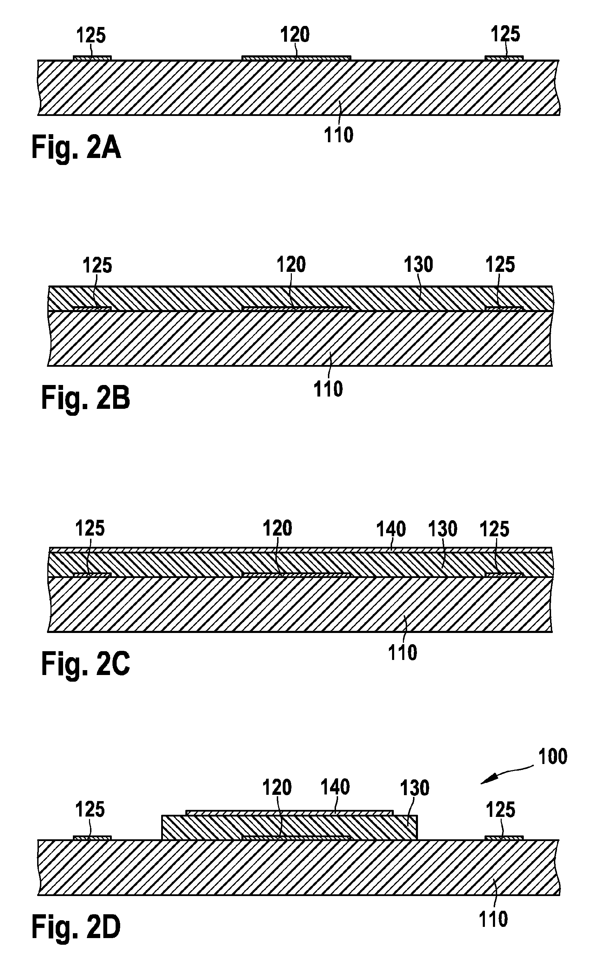

Figur 1 zeigt ein Ablaufdiagramm eines Verfahrens zur gemeinsamen Herstellung von integrierten Schaltkreisen 100 mit einer Antennenanordnung. Einzelne Verfahrensschritte dieses Verfahrens sind in den schematischen seitlichen Schnittdarstellungen der Figuren 2A bis 2D veranschaulicht.

Zu Beginn des Verfahrens wird in einem Verfahrensschritt 200 ein Substrat 110 mit einer Vielzahl an integrierten Schaltungen bereitgestellt. Bei dem Substrat 110 kann es sich um einen vorprozessierten Wafer handeln. In Betracht kommt insbesondere ein MMIC-Wafer, bei dem die integrierten Schaltungen für einen Betrieb bei Frequenzen im Mikrowellenbereich ausgebildet sind. Ein schematischer Ausschnitt des Substrats 110 ist in der seitlichen Schnittdarstellung von Figur 2A abgebildet. Das Substrat 110 weist neben den integrierten Schaltungen (nicht dargestellt) den einzelnen Schaltungen zugeordnete erste Antennenschichten 120 (Patch bzw. Strahlerfläche) auf, von denen in Figur 2A und den folgenden Figuren lediglich eine Antennenschicht 120 dargestellt ist. Die Antennenschichten 120 sind hierbei an die integrierten Schaltungen gekoppelt. Darüber hinaus weist das Substrat 110 Kontaktflächen (Bondpads) 125 auf, mit deren Hilfe ein (später vereinzelter) integrierter Schaltkreis 100 bzw. dessen integrierte Schaltung kontaktiert werden kann.

Die Antennenschichten 120 und Kontaktflächen 125 können beispielsweise gemeinsam durch großflächiges Aufbringen einer leitfähigen bzw. metallischen Schicht auf das Substrat 110 und Strukturieren dieser Schicht erzeugt werden. Mögliche in Betracht kommende Materialien für die Antennenschichten 120 und Kontaktflächen 125 sind beispielsweise Kupfer, Aluminium oder Gold.

In einem weiteren Verfahrensschritt 210 wird ein Trägermaterial großflächig auf die Oberfläche des Substrats 110 aufgebracht, so dass wie in Figur 2B dargestellt eine die Antennenschichten 120 und die Kontaktflächen 125 bedeckende Trägerschicht 130 erzeugt wird. Das Aufbringen des Trägermaterials für die Schicht 130 auf die Oberfläche des Substrats 110 erfolgt vorzugsweise durch einen Aufschleuderprozess bzw. eine Rotationsbeschichtung, wobei sich das Substrat 110 dreht.

Das Material der Trägerschicht 130 ist für Hochfrequenzanwendungen geeignet und weist daher Eigenschaften wie insbesondere eine geringe relative Permittivität und eine geringe Strahlungsabsorption auf, um lediglich geringe Strahlungsverluste im Betrieb eines integrierten Schaltkreises 100 zu bewirken. Als Trägermaterial wird vorzugsweise ein Kunststoffmaterial wie insbesondere Polyimid eingesetzt. Alternativ können auch andere Kunststoffe bzw. Polymermaterialien sowie in der Halbleitertechnik eingesetzte Fotolackmaterialien verwendet werden. Neben der Verwendung als Abstandsschicht in der Antennenanordnung eines integrierten Schaltkreises 100 kann die Trägerschicht auch als Passivierungsschicht für das Substrat 110 bzw. für die an der Substratoberfläche vorliegenden Schaltungsstrukturen und -schichten fungieren.

Eine zuverlässige Funktionsweise der Antennenanordnung eines integrierten Schaltkreises 100 setzt eine definierte Dicke der Trägerschicht 130 voraus. Zu diesem Zweck wird daher in einem weiteren Verfahrensschritt 220 geprüft, ob die Dicke der Trägerschicht 130 innerhalb der gewünschten Anforderungen liegt. Zur Dickenprüfung kann (nach einem eventuellen Ausbacken oder Aushärten der Trägerschicht 130) beispielsweise ein spektrometrisches oder ellipsometrisches Messverfahren durchgeführt werden.

Falls die Trägerschicht 130 den Vorgaben nicht entspricht und eine zu große Dicke aufweist, wird in einem weiteren Verfahrensschritt 230 die Trägerschicht 130 durch Entfernen oder Abschleifen von überschüssigem Trägermaterial verdünnt. Ein hierfür in Betracht kommendes Verfahren ist zum Beispiel ein CMP-Prozess (chemisch mechanisches Polieren). Falls die Dicke der Trägerschicht 130 die gewünschten Anforderungen erfüllt, kann ein derartiger Verfahrensschritt 230 auch entfallen.

Um sicherzugehen, dass die Trägerschicht 130 eine vorgegebene Dicke nicht unterschreitet, kann eine entsprechend ausreichende Menge von Trägermaterial auf das Substrat 110 aufgebracht werden. Sofern die Dickenanforderungen dennoch unterschritten werden, kann die gesamte Trägerschicht 130 von der Oberfläche des Substrats 110 entfernt und der Verfahrensschritt 210 (Aufbringen von Trägermaterial) wie in Figur 1 anhand eines gestrichelten Pfeils angedeutet wiederholt werden.

In einem weiteren Verfahrensschritt 240 wird eine leitfähige Schicht 140 wie in Figur 2C dargestellt großflächig auf die auf der Substratoberfläche erzeugte Trägerschicht 130 aufgebracht. Bei der leitfähigen Schicht 140 kann es sich wie in Figur 1 angedeutet um eine metallische Schicht (Metallisierung), beispielsweise um eine Kupferschicht handeln. Alternativ ist der Einsatz anderer Materialien bzw. Metalle wie zum Beispiel Aluminium oder Gold möglich. Das Ausbilden der Schicht 140 kann beispielsweise durch Durchführen einer elektrochemischen (galvanischen) Abscheidung oder eines Sputterprozesses erfolgen.

In einem weiteren Verfahrensschritt 250 wird die leitfähige bzw. metallische Schicht 140 strukturiert, um wie in Figur 2D dargestellt als zweite Antennenschicht(en) 140 in einem Bereich über der (den) ersten Antennenschicht(en) 120 zu fungieren. Zu diesem Zweck wird beispielsweise ein fotolithographisches Strukturierungsverfahren durchgeführt, bei dem die Schicht 140 mit einem Fotolack beschichtet, der Fotolack selektiv belichtet und entwickelt, und nachfolgend ein Teil der Schicht 140 in einem Ätzprozess entfernt wird, wobei der entwickelte Fotolack als Ätzmaske fungiert. Die zweite Antennenschicht 140 kann hierbei wie in Figur 2D dargestellt eine größere Breite bzw. größere laterale Abmessungen aufweisen als die erste Antennenschicht 120.

Nach dem Strukturieren der Schicht 140 wird auch die Trägerschicht 130 in einem Verfahrensschritt 260 einer Strukturierung unterzogen, wodurch die Kontaktflächen 125 wie in Figur 2D dargestellt freigelegt werden. Zum Strukturieren der Trägerschicht 130 kann wie bei der Schicht 140 ein fotolithographischer Strukturierungs- und Ätzprozess durchgeführt werden. Alternativ kann die Trägerschicht 130 auch auf andere Weise, beispielsweise durch selektives Entfernen mithilfe eines Lasers, strukturiert werden. Nach dem Verfahrensschritt 260 verbleibt die Trägerschicht 130 lediglich in Bereichen unter der Antennenschicht 240 bzw. zwischen den Antennenschichten 120, 240.

Anstelle das Strukturieren der leitfähigen Schicht 140 und der Trägerschicht 130 nacheinander in getrennten Prozessen durchzuführen, können die beiden Schichten 130, 140 wie in Figur 1 dargestellt alternativ in einem gemeinsamen Verfahrensschritt 270 strukturiert werden, wodurch sich das Herstellungsverfahren einfacher gestaltet. In einem solchen Fall können die beiden Schichten 130, 140 nach erfolgter Strukturierung entgegen der Darstellung von Figur 2D die gleichen lateralen Abmessungen aufweisen.

Im Anschluss an die vorstehend beschriebenen Verfahrensschritte können weitere Verfahrensschritte 280 erfolgen, in deren Verlauf das Substrat 110 weiterverarbeitet wird. In Betracht kommen hierbei insbesondere ein Rückdünnen des Substrats 110 und ein an dem Substrat 110 durchgeführter Sägeprozess, um den in Figur 2D dargestellten integrierten Schaltkreis 100 mit der Antennenanordnung zu vereinzeln bzw. eine Vielzahl an voneinander getrennten integrierten Schaltkreisen 100 zu erzeugen. Nach der Vereinzelung kann ein integrierter Schaltkreis 100 des Weiteren in ein Gehäuse eingebracht oder auf einer Leiterplatte befestigt werden.

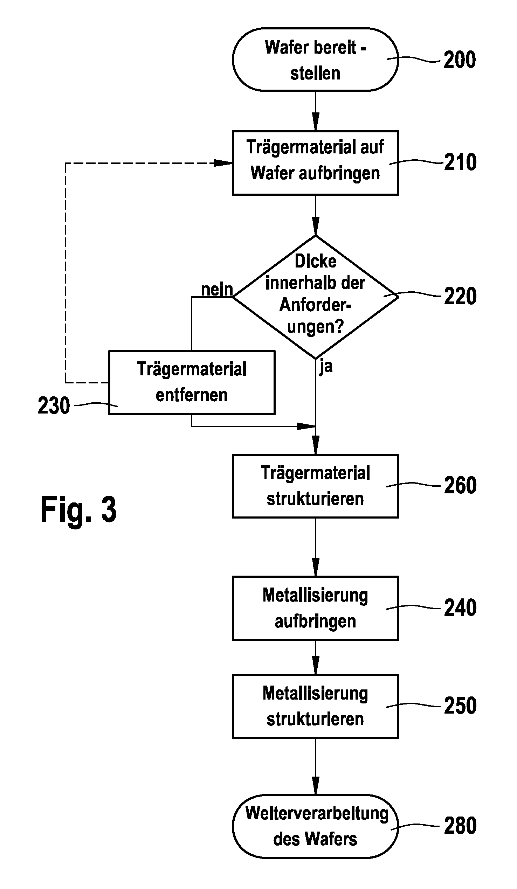

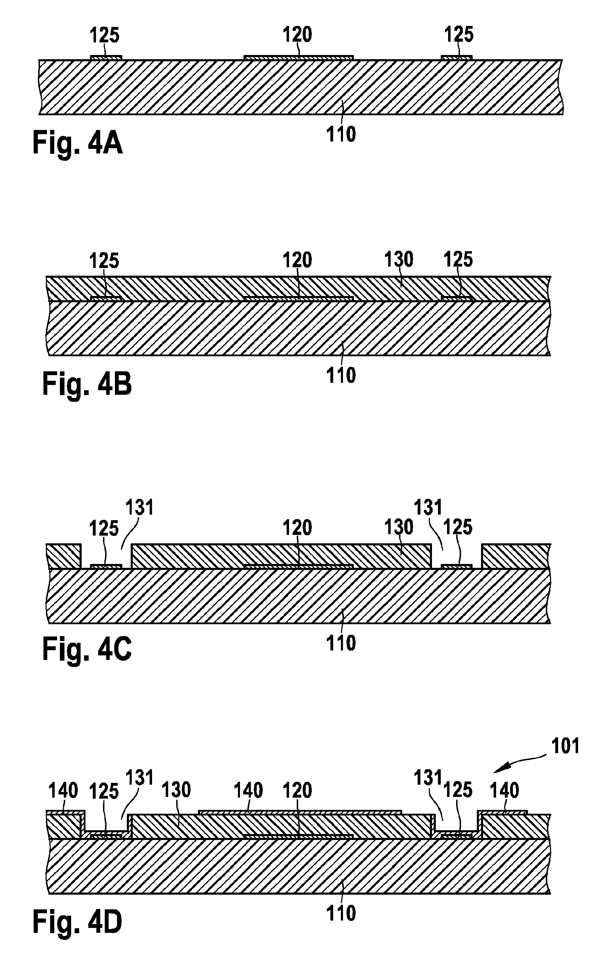

Figur 3 zeigt ein Ablaufdiagramm eines weiteren Verfahrens zur gemeinsamen Herstellung von integrierten Schaltkreisen 101 mit einer Antennenanordnung. Einzelne Verfahrensschritte dieses Verfahrens sind in den schematischen seitlichen Schnittdarstellungen der Figuren 4A bis 4D veranschaulicht. Das Verfahren weist die gleichen Verfahrensschritte auf wie das anhand der Figuren 1 und 2A bis 2D beschriebene Verfahren, welche jedoch zum Teil in einer anderen Reihenfolge durchgeführt werden. Im Hinblick auf Details zu übereinstimmenden Verfahrensschritten und Komponenten wird daher auf die obigen Ausführungen Bezug genommen.

Zu Beginn des Verfahrens wird in einem Verfahrensschritt 200 ein Substrat 110 mit einer Vielzahl an integrierten Schaltungen bereitgestellt, bei dem es sich beispielsweise um einen MMIC-Wafer handeln kann. Das Substrat 110 weist darüber hinaus den einzelnen Schaltungen zugeordnete erste Antennenschichten 120 und Kontaktflächen 125 auf (siehe Figur 4A).

In einem weiteren Verfahrensschritt 210 wird ein Trägermaterial großflächig auf die Substratoberfläche aufgebracht, so dass wie in Figur 4B dargestellt eine die Antennenschichten 120 und die Kontaktflächen 125 bedeckende Trägerschicht 130 erzeugt wird. Hieran anschließend wird in einem Verfahrensschritt 220 die Dicke der Trägerschicht überprüft, sowie bei Überschreiten der Dickenanforderungen die Trägerschicht 130 in einem Verfahrensschritt 230 verdünnt. Bei Unterschreiten der Dickenanforderungen kann die Trägerschicht 130 gegebenenfalls vollständig abgetragen und erneut auf dem Substrat 110 erzeugt werden. Nachfolgend wird die Trägerschicht 130 in einem Verfahrensschritt 260 strukturiert, wodurch die Kontaktflächen 125 freilegende Aussparungen 131 in der Trägerschicht 130 ausgebildet werden (siehe Figur 4C). Die Trägerschicht 130 kann hierbei nicht nur im Bereich der Kontaktflächen 125, sondern auch an anderen Stellen von der Oberfläche des Substrats 110 entfernt werden (nicht dargestellt). Hierunter fallen beispielsweise Substratbereiche, in welchen ein Durchtrennen des Substrats 110 in einem (späteren) Sägeprozess erfolgt.

In einem nachfolgenden Verfahrensschritt 240 wird eine leitfähige bzw. metallische Schicht 140 großflächig auf die Trägerschicht 130 und auf die freigelegten Oberflächenbereiche des Substrats 110 bzw. die freigelegten Kontaktflächen 125 aufgebracht. Die ausgebildete Schicht 140 wird des Weiteren in einem Verfahrensschritt 250 strukturiert, wodurch die in Figur 4D dargestellte Struktur erzeugt wird.

Die Schicht 140 befindet sich hierbei nicht nur auf der Trägerschicht 130 in einem Bereich über der ersten Antennenschicht 120, um als zweite Antennenschicht 140 zu fungieren. Ein Teil der Schicht 140 verbleibt außerhalb dieses Bereichs auf der Trägerschicht 130, Seitenwänden der Aussparungen 131 und der zuvor freigelegten Substratoberfläche bzw. den Kontaktflächen 125. In diesen Abschnitten werden die Kontaktflächen 125 durch die leitfähige Schicht 140 kontaktiert, welche auf diese Weise als Umverdrahtungsstruktur fungieren kann. Eine elektrische Verbindung zu den Kontaktflächen 125 kann hierbei durch Kontaktieren des mit den Kontaktflächen 125 verbundenen Teils der leitfähigen Schicht 140 außerhalb der Aussparungen 131 erfolgen.

Im Anschluss an die beschriebenen Verfahrensschritte können weitere Verfahrensschritte 280 zur Weiterverarbeitung des Substrats 101 durchgeführt werden. Hierunter fällt insbesondere ein Rückdünnen des Substrats 110 und ein an dem Substrat 110 durchgeführter Sägeprozess, um den in Figur 4D dargestellten integrierten Schaltkreis 101 mit der Antennenanordnung zu vereinzeln bzw. eine Vielzahl an solchen getrennten integrierten Schaltkreisen 101 auszubilden.

Die anhand der Figuren erläuterten Ausführungsformen stellen bevorzugte bzw. beispielhafte Ausführungsformen der Erfindung dar. Anstelle der beschriebenen Ausführungsformen sind weitere Ausführungsformen vorstellbar, welche weitere Abwandlungen oder Kombinationen umfassen können. Im Hinblick auf das Entfernen (eines Teils) einer Trägerschicht 230 nach dem Aufbringen auf ein Substrat 110 ist es beispielsweise vorstellbar, ein Überprüfen der Dicke der Schicht 130 (Verfahrenschritt 220) wegzulassen. Es ist beispielsweise möglich, nach jedem Aufbringen (einer ausreichenden Menge) von Trägermaterial auf das Substrat 110 einen Teil des Trägermaterials wieder zu entfernen, um eine vorgegebene Dicke der Trägerschicht 130 mit einer hohen Genauigkeit festzulegen.

## Patentansprüche

1. Verfahren zum Herstellen eines integrierten Schaltkreises (100, 101) mit einer Antennenanordnung, umfassend die Verfahrensschritte:
- Bereitstellen eines Substrats (110), wobei das bereitgestellte Substrat (110) eine integrierte Schaltung und eine an einer Oberfläche des Substrats angeordnete erste Antennenschicht (120) aufweist,
- Ausbilden einer Trägerschicht (130) auf der Oberfläche des bereitgestellten Substrats (110), wobei die Trägerschicht (130) die erste Antennenschicht (120) bedeckt,
- Ausbilden einer leitfähigen Schicht (140) wenigstens auf der Trägerschicht (130),
- Strukturieren der leitfähigen Schicht (140) zum Ausbilden einer zweiten Antennenschicht (140) in einem Bereich über der ersten Antennenschicht (120), und
- Strukturieren der Trägerschicht (130).

2. Verfahren nach Anspruch 1, wobei das bereitgestellte Substrat (110) weiter eine an der Oberfläche angeordnete Kontaktfläche (125) aufweist, wobei die Kontaktfläche (125) durch das Ausbilden der Trägerschicht (130) bedeckt und durch das Strukturieren der Trägerschicht (130) freigelegt wird.

3. Verfahren nach einem der Ansprüche 1 oder 2, wobei das Strukturieren der leitfähigen Schicht (140) und das Strukturieren der Trägerschicht (130) gemeinsam durchgeführt wird.

4. Verfahren nach einem der Ansprüche 1 oder 2, wobei das Strukturieren der Trägerschicht (130) vor dem Ausbilden der leitfähigen Schicht (140) durchgeführt wird.

5. Verfahren nach einem der vorhergehenden Ansprüche, weiter umfassend:
- Verdünnen der Trägerschicht (130) nach dem Ausbilden der Trägerschicht (130) auf der Oberfläche des bereitgestellten Substrats (110).

6. Verfahren nach einem der vorhergehenden Ansprüche, wobei die Trägerschicht (130) ein Kunststoffmaterial, insbesondere Polyimid, aufweist.

7. Verfahren nach einem der vorhergehenden Ansprüche, wobei das Ausbilden der Trägerschicht (130) auf der Oberfläche des bereitgestellten Substrats (110) das Durchführen einer Rotationsbeschichtung umfasst.

8. Verfahren nach einem der vorhergehenden Ansprüche, wobei das Ausbilden der leitfähigen Schicht (140) auf der Trägerschicht (130) das Durchführen eines der folgenden Prozesse umfasst:
- elektrochemische Abscheidung; oder
- Sputterprozess.

9. Verfahren nach einem der vorhergehenden Ansprüche, weiter umfassend:
- Durchführen eines Sägeprozesses.

10. Integrierter Schaltkreis mit einer Antennenanordnung, aufweisend:
ein Substrat (110), wobei das Substrat eine integrierte Schaltung und eine an einer Oberfläche des Substrats angeordnete erste Antennenschicht (120) aufweist,
eine auf der Oberfläche des Substrats (110) angeordnete Trägerschicht 130), wobei die Trägerschicht (130) die erste Antennenschicht (120) bedeckt, und
eine auf der Trägerschicht (130) angeordnete zweite Antennenschicht (140) in einem Bereich über der ersten Antennenschicht (120),
**dadurch gekennzeichnet, dass**
die Trägerschicht (130) unmittelbar auf der Oberfläche des Substrats (110) und auf der ersten Antennenschicht (120) angeordnet ist.
